# EUROPÄISCHE PATENTANMELDUNG

(11) **EP 2 692 528 A1**
(43) Veröffentlichungstag der Anmeldung: **05.02.2014**
(21) Anmeldenummer: 12178540.6
(22) Anmeldetag: 30.07.2012
(51) Int. Cl.: B32B 37/00, B32B 37/10, H01L 41/09

(54) **Ablage von Folien**

(71) Anmelder: Technische Universität Darmstadt, 64285 Darmstadt (DE)
(72) Erfinder: Mößinger, Holger, 64295 Darmstadt (DE)
(74) Vertreter: Stumpf, Peter

(57) **Zusammenfassung**

Die Erfindung betrifft ein neuartiges Verfahren und eine entsprechende Vorrichtung zur Ablage einer Folie auf einer Unterlage. Dabei wird die Oberseite der Folie mit Ladungen belegt, um eine Anheftung der Folie an der Unterlage zu bewirken. Das Verfahren kann insbesondere bei der Herstellung von sogenannten Dielektrischen Elastomer Stapel Wandlern (DESWs) angewendet werden.

## Beschreibung

Die vorliegende Erfindung betrifft das Gebiet der Verarbeitung von Folien, insbesondere die blasenfreie oder verwerfungsfreie Ablage von Folien auf beliebig geformten Oberflächen, insbesondere auf gekrümmten oder ebenen Oberflächen. Weiterhin betrifft die Erfindung die Herstellung von Dielektrischen Elastomer Stapel Wandlern (DESW).

### Stand der Technik

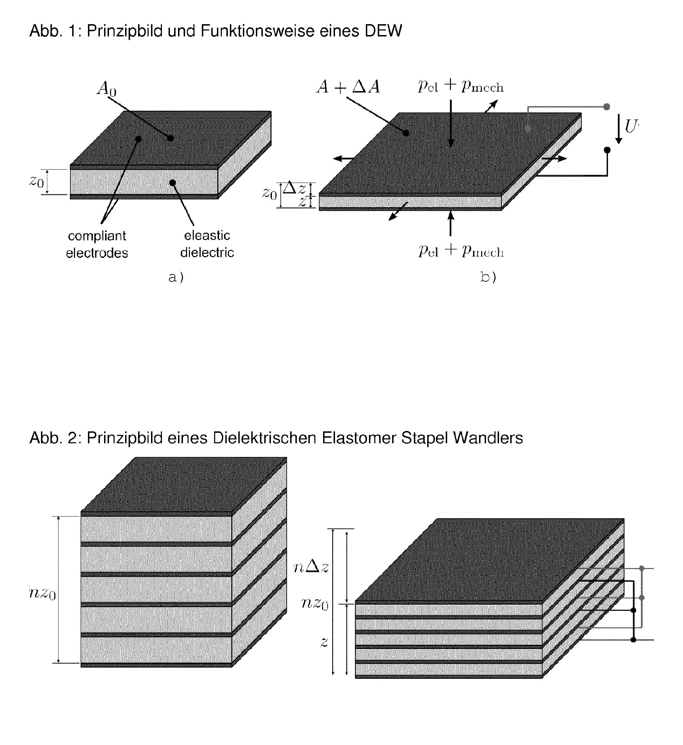

Die erreichbare Auslenkung der DEW hängt von mehreren Einflussgrößen ab. Neben Materialparametern des Elastomers wie dem Elastizitätsmodul, der Dielektrizitätszahl und der Durchbruchfeldstärke, gehen auch die Dicke der Elastomerschicht und die angelegte elektrische Spannung bzw. die elektrische Feldstärke in die Auslenkung ein. Die Materialparameter sind durch die Auswahl eines Elastomers festgelegt. Eine größere Anfangsdicke ***z*₀** erhöht zwar auf den ersten Blick die Gesamtauslenkung, bedeutet bei gleicher Spannung ***U*** eine Verringerung des elektrischen Feldes E, was wiederum zu einer Verringerung der Auslenkung führt. Eine Erhöhung der elektrischen Betriebsspannung auf mehrere Kilovolt kann diesen Effekt zwar wieder ausgleichen, jedoch ist es im Einsatzfall gewünscht, eher mit niedrigen Spannungen (wesentlich kleiner 1 kV) zu arbeiten. Deshalb macht es zur Erhöhung der Auslenkung mehr Sinn, mehrere einzelne Wandler "aufeinander zu stapeln", wie dies in Abb. 1 und 2 zu sehen ist.

Hier trägt jede einzelne Schicht einen Teil zur Gesamtauslenkung bei, so dass sich bei n-Schichten die n-fache Auslenkung ergibt, ohne dass die anderen Betriebsgrößen verändert werden müssen. Alternativ kann bei gleicher Auslenkung im Vergleich zum einzelschichtigen Wandler die Schichtdicke n-mal geringer ausfallen, was eine weitere Absenkung der Betriebsspannung erlaubt. Nachteilig ist allerdings, dass der Stapelaufbau weitaus komplizierter ist als die Herstellung eines einzelschichtigen Wandlers.

Zur Herstellung von DESW müssen die einzelnen Wandlerschichten übereinander geschichtet werden. Hierzu wurde am Institut für Elektromechanische Konstruktionen (EMK) eine Anlage entwickelt, die als erste voll automatisiert DESW herstellen kann [Sch05]. Das dabei angewendete Verfahren ist nachfolgend beschrieben. Inzwischen gibt es weitere Ansätze zur Herstellung von DESW auf die nachfolgend auch kurz eingegangen wird.

### Herstellungsverfahren am Institut für Elektromechanische Konstruktionen

Die bisher am EMK gefertigten Stapelaktoren bestehen aus dem zweikomponentigen, thermisch vernetzenden Silikon und Graphit als Elektrodenmaterial.

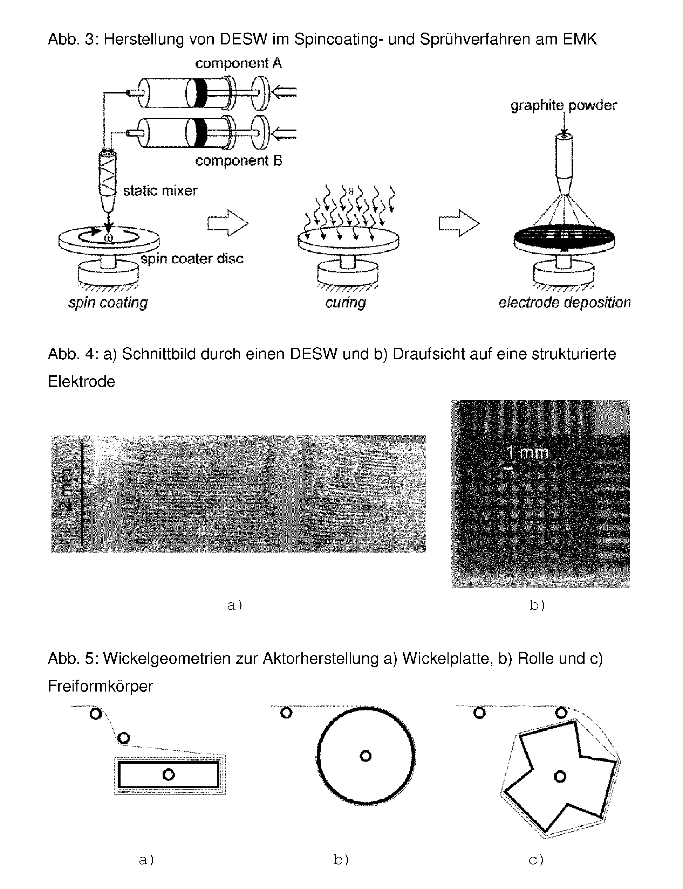

Die Wandler werden in einem Spincoating Prozess hergestellt. Der Prozessablauf ist in Abbildung 3 zu sehen. Im ersten Schritt werden die zwei Silikonkomponenten gemischt, und auf einen Schleuderteller aufgebracht. Durch die Schleuderparameter wird die Dicke der Elastomerschicht eingestellt. Nach dem Schleudern wird die Schicht thermisch vernetzt. Im Anschluss wird durch eine Schattenmaske eine strukturierte Graphitelektrode aufgebracht. Dieser Ablauf wird dann so lange wiederholt, bis die gewünschte Schichtanzahl erreicht ist. Typische Schichtanzahlen liegen zwischen 5 und 200 Schichten bei Schichtdicken zwischen typisch 5 µm und 100 µm. Abb. 4a) zeigt einen Schnitt durch einen Wandler mit ca. 40 Schichten bei einer Schichtdicke von ca. 50 µm. Abb. 4b) zeigt eine Draufsicht auf einen Wandler mit strukturierter Elektrode.

Verfahrensbedingt ist die Herstellung der Wandler durch Spincoating auf Durchmesser kleiner 100 mm beschränkt. Die am EMK hergestellten Wandler haben typischerweise Durchmesser von maximal 70 mm. Zur Herstellung von Wandlern mit größerem Durchmesser ist es deshalb nötig auf andere Herstellungsverfahren auszuweichen.

### Weitere Herstellungsverfahren für DESW

Um die Limitierungen des Spincoatingverfahrens zu überwinden sind verschiedene weitere Verfahren zur Herstellung von DESW Gegenstand der Forschung. Hierbei kann unterschieden werden zwischen der Herstellung der Wandler aus Vorprodukten, wie z.B. die am EMK eingesetzte Silikonkomponenten auf der einen Seite, sowie dem Herstellen der Schichten aus fertigen Folienmaterialien auf der anderen Seite. Zur Herstellung aus Vorprodukten laufen Untersuchungen die sich beispielsweise mit dem direkten Drucken von großflächigen Elastomerwandlern beschäftigen. Die Herstellung aus fertigem Folienmaterial wurde am EMK im Rahmen des jetzt abgeschlossenen BMBF Förderprojekts BelievE (FKZ: 13N10633) untersucht. Im Rahmen dieses Projekts ist das folgende Verfahren zur Herstellung von DESW aus Folienmaterial entwickelt worden.

### Verfahren zur Herstellung von DESW aus Folienmaterial

Die Herstellung von DESW aus fertigem Folienmaterial bietet Vorteile gegenüber der Herstellung von DESW aus Einzelkomponenten. Es ist möglich geeignete großflächige Folien in industriellem Maßstab kostengünstig herzustellen. Geeignetes Folienmaterial ist bereits vorhanden, oder wird von den Materialherstellern zurzeit intensiv entwickelt. Es ist daher nötig, ein Verfahren zu entwickeln, dass es erlaubt das auf Endlosrollen gelieferte Folienmaterial zu DESW zu verarbeiten.

Die Anforderungen die an das Verfahren gestellt werden sind:
- Herstellung großflächiger Aktoren (im Prototypenstadium ≥ DinA5, später größer).
- Herstellung möglichst aus Endlosfolienmaterial
- Automatisierbarkeit des Verfahrens
- Herstellung auf möglichst ebener Grundfläche um ein Verbiegen der Wandler nach der Herstellung zu vermeiden.

Für den Entwurf des Verfahrens wurden zuerst verschiedene Geometrien untersucht, auf die der Aktor aufgebaut werden kann. Abbildung 5 zeigt beispielhaft drei der untersuchten Geometrien.

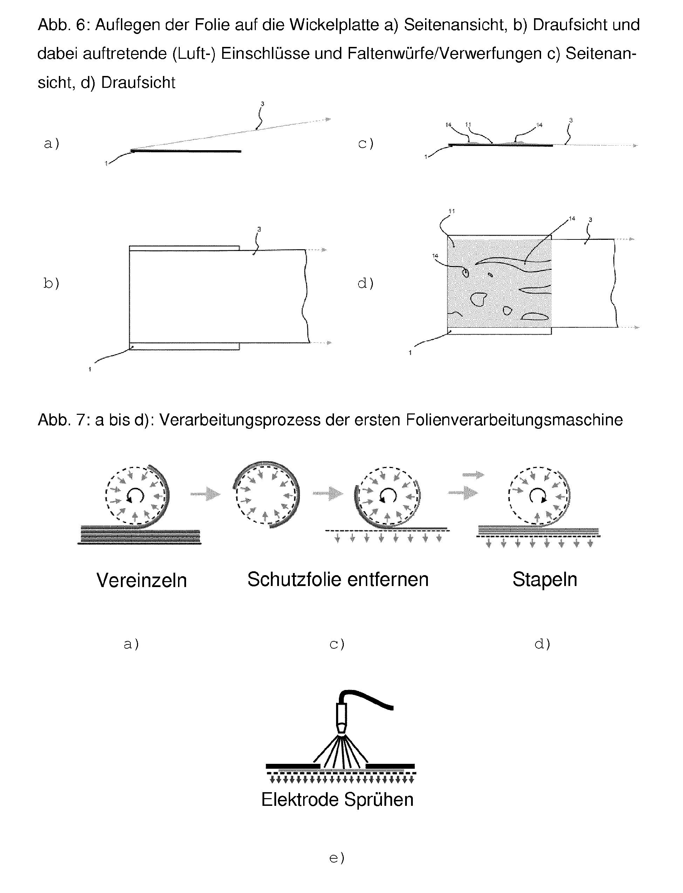

Die Abbildung 6a zeigt das Wickeln der Folie auf eine Wickelplatte. Eine möglichst dünne Wickelplatte stellt grundsätzlich die ideale Grundgeometrie für die Aktorfertigung dar. Dabei wird eine Endlosfolie so lange um die Platte gewickelt werden bis die gewünschte Anzahl an Schichten erreicht ist. Auf diese Weise können in einem Durchlauf direkt zwei Aktoren hergestellt werden, einer auf der Oberseite, einer auf der Unterseite.

Das Wickeln auf eine ebene Platte hat jedoch den in Abbildung 6 gezeigten Nachteil. Wenn die Folie auf die Wickelplatte aufgelegt wird geschieht dies auf einer großen Fläche gleichzeitig und es bilden sich Einschlüsse in Form von Luftblasen oder/und Verwerfungen. Dieses Problem wird umso kritischer, je dünner und weicher die abzulegenden Folien sind.

Andere Forschungsgruppen verwenden zur Vermeidung des Problems der Einschlüsse und Verwerfungen Verfahren, die wie in Abbildung (5b) gezeigt den Wandler auf Rollen fertigen [Ran08]. Dort ist die Auflage der Folie nicht flächig, sondern nur linienförmig und das Problem wird abgemindert und einfacher zu handhaben. Allerdings ist dann der so hergestellte Wandler nicht mehr plan aufliegend, sondern weist eine Verbiegung auf, was nicht gewünscht ist. Eine weitere denkbare Möglichkeit sind Freiformkörper, mit speziell gestalteten Oberflächen beispielsweise wie in Abbildung (5c) gezeigt, welche einen Kompromiss zwischen Verwerfungsbildung und Verbiegung der Aktoren darstellen, aber gleichzeitig andere Probleme mit sich bringen.

Alle vorgenannten Verfahren sind haben jedoch weiterhin den Nachteil auch anfällig für die Bildung von Blasen und/oder Verwerfungen bei der Ablage der Folien zu sein.

### Aufgabe

Es ist daher eine erste Aufgabe der Erfindung ein Verfahren vorzusehen, welches die Ablage von Folien unter Vermeidung der Nachteile im Stand der Technik ermöglicht.

Es ist eine zweite Aufgabe der Erfindung eine passende Vorrichtung zur Durchführung des Verfahrens vorzusehen.

Es eine dritte und vierte Aufgabe der Erfindung ein passendes Verfahren und eine passende Vorrichtung zur Herstellung von Dielektrischen Elastomer Stapel Wandlern (DESW) vorzusehen. Die erste bis vierte Aufgabe wird gelöst durch den Gegenstand der Ansprüche 1 und 12 bzw. 17 und 19.

Im Folgenden werden einige Ausführungsbeispiele der Erfindung, dargestellt in den folgenden Abbildungen oder im Text näher erläutert.

Es zeigen:
Abb. 1: Ein Prinzipbild und Funktionsweise eines DEW
Abb. 2: Ein Prinzipbild eines Dielektrischen Elastomer Stapel Wandlers
Abb. 3: Herstellung von DESW im Spincoatingverfahren am EMK
Abb. 4: a) Schnittbild durch einen DESW und b) Draufsicht auf die strukturierte Elektrode
Abb. 5: Wickelgeometrien zur Aktorherstellung mit a) Wickelplatte, b) Rolle und c) Freiformkörper
Abb. 6: a), b) Auflegen der Folie auf die Wickelplatte und c) dabei auftretende (Luft-) Einschlüsse und Faltenwürfe
Abb. 7: a bis d): Verarbeitungsprozess einer ersten Folienverarbeitungsmaschine
Abb. 8 a, b, c, d, e: Erweiterter Verarbeitungsprozess der ersten Folienverarbeitungsmaschine in einem weiteren Ausführungsbeispiel
Ább. 9: Grundstruktur des bevorzugten, neuesten Folienverarbeitungssystems mit Wickelvorrichtung statt einer Rollvorrichtung
Abb. 10: Folienverarbeitungssystem mit beispielhafter Elektrodenkammgeometrie zur Anhaftung der Folie auf der Wickelplatte
Abb. 11: Prozessablauf des Folienverarbeitungssystems

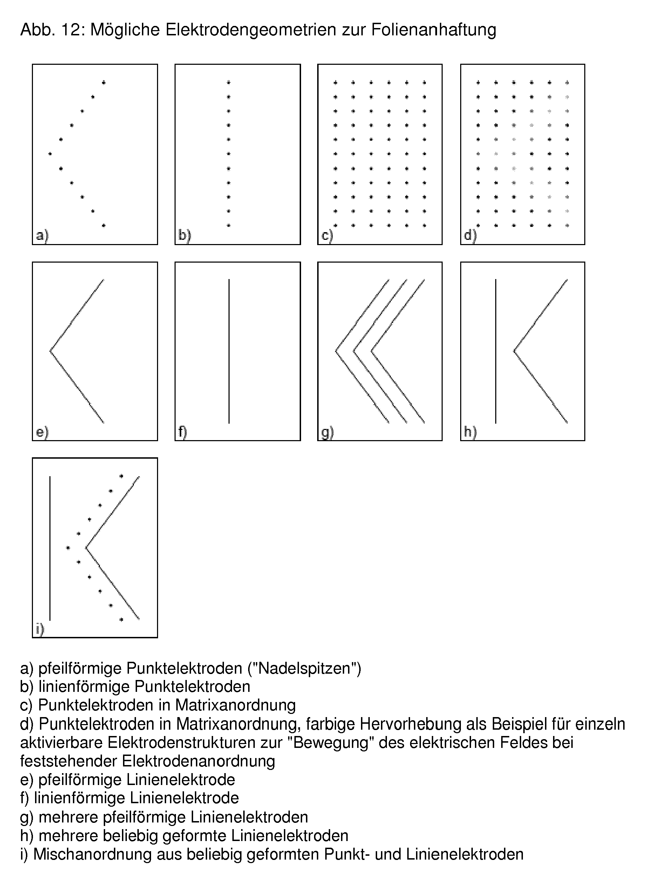

Abb. 12: Mögliche Elektrodengeometrien zur Felderzeugung bei der Folienanhaftung (Draufsichten) (a) bis i)

Um die Verbiegung der Aktoren, welche aber nur für manche Anwendungen besonders nachteilig ist, zu vermeiden, musste also eine Möglichkeit gefunden werden, die Folien des Wandlers - möglichst blasen und verwerfungsfrei- abzulegen. Eine Variante dies zu erfüllen, ist die Ablage auf einer ebenen Fläche.

Dazu wurde in einem ersten Schritt der in Abbildung 7 gezeigte Herstellungsprozess entworfen, der die Vorteile von Rolle und Wickelplatte miteinander verknüpft.

Die Folien werden zuerst auf eine Rolle gewickelt und dann von dieser Rolle auf einer ebenen Platte abgelegt. Anschließend werden die Elektroden auf die jeweils obenliegende Folie aufgebracht, so diese nicht bereits in der Folie integriert sind. Der Ablauf wird dann wieder so oft wiederholt, bis die gewünschte Schichtanzahl erreicht ist.

Allerdings muss für dieses Verfahren die Folie zuerst zu Folienbögen vereinzelt werden um, von der Rolle aufgenommen und wieder auf der Platte abgelegt werden zu können. Mit diesem Verfahren ist es möglich, die Folienbögen nahezu verwerfungsfrei aufeinander zu stapeln. Zum selektiven Festhalten und Abstoßen der Folien an der Rolle und Platte wurde ein Unterdrucksystem eingesetzt. Auf der Platte funktioniert der Unterdruck jedoch nur solange bis der erste Folienbogen abgelegt ist. Dieser verdeckt dann die Öffnungen für die Druckluft und der zweite Bogen kann nicht mehr ordentlich fixiert werden, der Stapel wird instabil. Jedoch konnte das Verfahren, durch das neue Verfahren der Ablage gemäß Anspruch 1 deutlich verbessert werden, so dass der Stapel sehr stabil wurde.

Beim Aufsprühen der Elektrode oder dem Aufbringen weiterer Schichten droht ein verrutschen des Stapels. Aus diesem Grund musste eine Möglichkeit gefunden werden, die einzelnen Schichten aufeinander haften zu lassen. Hierzu wurden verschiedene Methoden, wie z.B. Kleben, Verschweißen, Verschmelzen, Vernähen, etc., untersucht. Diese wurde jedoch alle verworfen, da sich der Einfluss der Verfahren auf die Performance des Wandlers als zu groß herausstellte.

Es ist jedoch bekannt, dass sich durch eine Aktivierung der Oberflächen mit Plasma, selbst bei sonst nicht aufeinander haftenden Medien wie Silikon, eine Haftung untereinander oder auf anderen Materialien erzielen lässt. Dies konnte auch an einzelnen Proben der zu verarbeitenden Folien nachgewiesen werden.

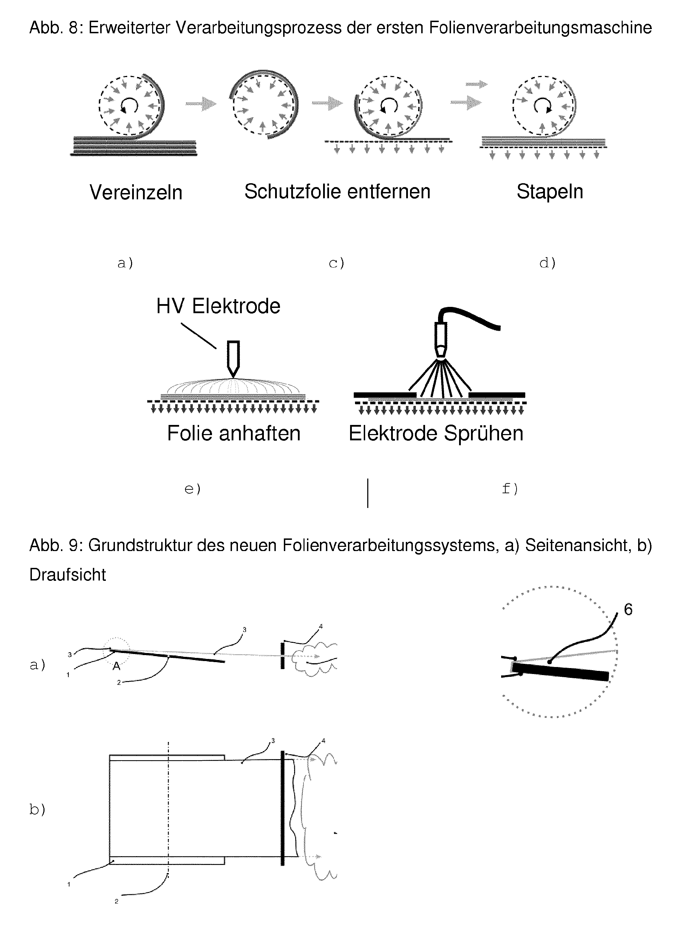

Allerdings schien es wenig erfolgsversprechend den dazu nötigen langwierigen Vakuum-Plasmaprozess praktikabel in die Fertigungsanlage zu integrieren, um jede einzelne Schicht plasmaaktivieren zu können. Es wurde also versucht, auf eine einfachere Art und Weise ein Plasma oder Ladungen zu erzeugen oder abzugeben um die Oberfläche der Folie so zu verändern, dass diese an der darunter liegenden Unterlage (oder letzten abgelegten Folienschicht) gut anhaftet oder die Oberfläche gar zu aktivieren. Hierzu wurden verschiedene Abgaben von Ladungen und auch einfache Koronaentladungen an einer spitzen Elektrode untersucht. Die nötige Aktivierung der Oberfläche ist jedoch mit dieser sehr energiearmen Variante der Plasmaerzeugung nicht erreicht worden. Allerdings zeigte sich überraschenderweise ein anderer Effekt. Durch den von der Elektrode erzeugten Ladungen(Ionenwind oder Koronaplasma) wird die Folie elektrostatisch aufgeladen und haftet damit an der darunterliegenden Folie. Diese Haftung reicht aus, um die Folie am Verrutschen zu hindern und so den Stapel weiter aufbauen zu können. Damit wurde der bisherige Fertigungsprozess um einen Schritt, das elektrostatische Anhaften der Folie, erweitert (siehe Abbildung 8).

Im weiteren Verlauf der Entwicklung zeigte sich, dass der Prozess des Vereinzelns und des Folientransports mit Hilfe der Rolle sich nur schwer reproduzierbar automatisieren lässt, da es Probleme beim Folienhandling gibt.

Mit den Erkenntnissen zur Folienanhaftung durch die Abgabe oder Erzeugung von Ladung auf der Oberfläche der Folie (etwa durch ein Koronaplasma etc.) war es jetzt jedoch möglich, das Verfahren zum Aufbringen der Folie auf die Unterlagenformen aus Abbildung (5) zu modifizieren.

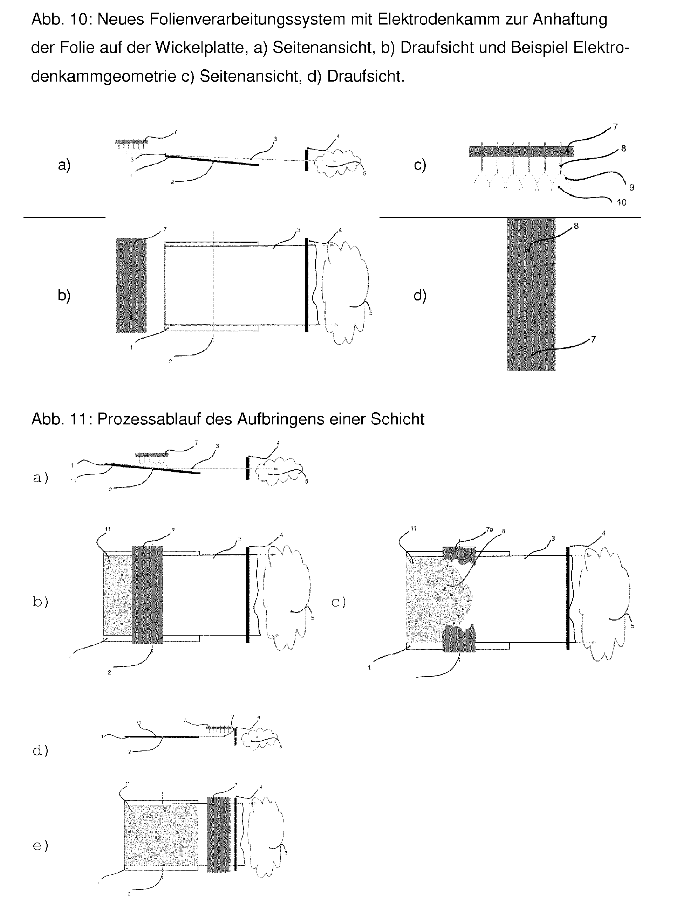

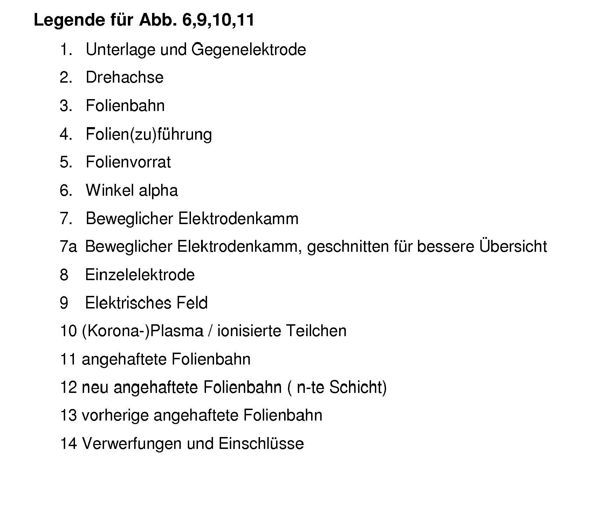

Es wurde ergänzt um den in Abbildung 10 gezeigten Elektrodenkamm. An diesem Kamm kann durch gezieltes Anlegen von Hochspannung zwischen Elektrodenkamm und Wickelplatte die Abgabe von Ladungen oder auch eine Koronaentladung (Koroaplasma) und damit ein Elektronen- (oder je nach elektrischer Polung auch ein Ionenwind) erzeugt werden, der die Folie elektrostatisch auflädt. Dabei wird zuerst wie in Abbildung 9 und 10 gezeigt die Folie soweit gewickelt bis diese unter einem (spitzen) Winkel zur Platte steht.

Der Winkel ist so gewählt, dass die zu verarbeitenden Folie sich gerade nicht von selbst an die Wickelplatte anlegt. Typische Werte liegen im Bereich von 3° bis 20°, bevorzugt 5-18 und besonders bevorzugt im Bereich von 6 bis 12 und 13 bis 17°. Dieser Wert wird im Laufe der Herstellung eines Aktors aber leicht -um rund 2-5°- variiert, um ein optimales Ergebnis zu erzielen.

Dann wird an der linken Kante in Abbildung 10 beginnend der Elektrodenkamm aktiviert und über Platte hinweg zur rechten Kante verfahren. Dabei kann die Wickelplatte langsam weitergedreht werden. Nachdem der Elektrodenkamm über die Platte gefahren wurde ist die Folie auf der Wickelplatte oder der darunterliegenden Folie angehaftet und die Platte wird um etwa eine Umdrehung weiter gedreht um die Prozedur auf der Rückseite zu wiederholen. Wenn nötig wird vor dem Weiterdrehen noch eine Elektrode aufgebracht. So lassen sich zwei Aktoren (einer auf Vorder- und Rückseite) gleichzeitig auf der Wickelplatte fertigen. Die in Abbildung 10c und 10d dargestellte und über der Platte verfahrene Elektrodenkammgeometrie kann auch anders aussehen, bzw. die Geometrie des vom Kamm erzeugten Ladungs- oder Plasmafeldes kann durch eine Matrixanordnung der Elektroden und die Variation der an den einzelnen Elektroden angelegten Spannungen bestimmt und über die Platte gelenkt werden.

In Abbildung 10d ist beispielhaft eine dreieckige Elektrodengeometrie dargestellt.

Die typischerweise für die DESW Herstellung verwendeten Folien sind aus Silikon und Polyurethan. Ihre Schichtdicken sollen möglichst gering sein und liegen momentan zwischen 20 µm und 200 µm. Die Herstellung dünnerer Folien ist Ziel aktueller Forschungsprojekte. Allerdings ist die elektrostatische Anhaftung weitgehen unabhängig von der Foliendicke, solange die Folien nicht zu steif sind. Folien bis 1 mm Dicke konnten auch sicher angehaftet werden. Allerdings dürfen die Folien für den Vorgang nicht hochleitfähig sein. Die aufgebrachten elektrischen Ladungen müssen zumindest kurzzeitig auf der Oberfläche gehalten werden können um eine Anziehung der Folien an die darunterliegende Folie oder Wickelplatte zu erreichen.

### Wirkung der Ladungen oder des Plasmas im Ablage- oder Wickelvorgang

Das Ziel der Abgabe an oder Erzeugung von Ladung auf der der Unterlage gegenüberliegenden Oberfläche der Folie ist es die Wirkung der blasen- und/oder verwerfungsfreien Anheftung der Folie an die Unterlage, welche auch wieder schon abgelegte Folienschichten sein können, zu erzielen.

Die in einer Extremform der Abgabe oder Erzeugung von Ladungen auf der Folienoberfläche erzeugte "Aktivierung der Folie" ist zur ersten Anheftung der Folie -zur Vermeidung von Blasenbildung oder/und Verwerfungen- nicht notwendig.

Die Aktivierung kann aber die Anheftung zeitlich länger aufrecht erhalten, da diese z.T. auch eine chemische Verbindung der Folie an die Unterlage bewirkt.

Im jetzigen Prototypen der Maschine werden -aufgrund der mild gewählten Parameter- die Ladungen nicht so erzeugt oder abgegeben, dass eine Aktivierung stattfindet.

Das Auflegen der Folien auf die Wickelplatte und die Verbindung der Folien untereinander beruht daher nahezu ausschließlich (je nach Verfahrensparametern) auf der elektrostatischen Anziehung der geladenen Folien. Je nach Leitfähigkeit der Folien kann diese Haftung auf Dauer nachlassen. Die Haftung durch die oberflächenaktivierende Wirkung des Plasmas spielt bisher nur eine untergeordnete Rolle, da die erzeugten Energien zu gering sind. Zur Verbesserung der dauerhaften Haftung wäre noch der Einbau eines höher energetischen Plasmagenerators und die Anpassung der Plasmaparameter auf das jeweilige Folienmaterial nötig und auch möglich. Erste Versuche zur verstärkten Oberflächenaktivierung außerhalb der Folienverarbeitungsmaschine zeigen bereits Erfolge.

Das Plasma und die Ladungsabgabe wurden bevorzugt in und mit Umgebungsluft hergestellt bzw. durchgeführt. Andere Gase sind vorstellbar.

Das Verfahren kann mit Foliendicken von rund 1µm, über 10µm, 20µm bis 100µm sowie 500µm bis hin zu 1 mm und darüber hinaus verwendet werden.

Die verwendeten Spannungen lagen in Abhängigkeit von den Abständen zwischen den Elektroden bei rund 6kV bis 15kV und auch darüber, d.h. bis 19 und 20kV, sowie bis hoch zu 30 oder 40 kV. Die Abstände zwischen den Elektroden lagen im Bereich von unter 1mm über 5mm und auch bis zu 10 bis 20mm, wobei die Wickelplatte als Gegenelektrode diente.

Bei Verwendung von 30-40 kV können größere Abstände oder auch die Erde als Gegenelektrode verwendet werden. Durch Anordnung der Wickelplatte nahezu auf Erdpotential und geeignete Isolation von oberer Elektrode und unterer Gegenelektrode (=Erde) kann darauf verzichtet werden die Wickelplatte direkt mit einem elektrischen Leiter zu verbinden.

Als Elektrodengeometrien, d.h. Geometrien der Elektroden oberhalb der abzulegenden Folie, wurden linien- oder auch dreicksartige Geometrien verwendet, wie diese in Abb. 11 dargestellt sind, welche als Ausführungsbeispiele alle gewinnbringend verwendet werden konnten.

In einem weiteren Ausführungsbeispiel wurde die Art der Elektrodengeometrie (bei einem quadratischen und rechteckigen Elektrodenfeld) dadurch geändert, dass die Elektroden während des Vorgangs des Ablegens in verschiedenen Geometrien "geschaltet", d.h. an diese eine Spannung angelegt wurde.

In einen weitere Ausführungsbeispiel, welches oben bereits kurz erläutert wurde, ist vorgesehen, dass sich die Elektrodenanordnung, während des Vorgangs des Ablegens der Folie auf der Unterlage über die Oberseite der Folie hinweg bewegt oder/und -des Weiteren- die Schaltung der Elektroden, entsprechend ggf. durch eine entsprechende Überwachungsvorrichtung, dennoch detektierten Verwerfungen oder drohenden Blasenbildungen, so gesteuert wird, dass diese Blasen oder und Verwerfungen vermieden werden. Eine solche Überwachungsvorrichtung kann optischer Natur sein, da sich Verwerfungen -bei Betrachtung der abzulegenden Folie von der Seite- durch Falten vor dem Ablegen ankündigen, welche -von der Seite durchleuchtet- die "Durchsichtigkeit" der Folie verändern.

Das erfindungsgemäße Verfahren zur blasen- oder/und verwerfungsfreien Ablage von Folien auf einer Unterlage kann für auch für leitfähige Folien eingesetzt werden. In diesem Falle ist dann die Rate der Abgabe oder/und Erzeugung von Ladungen auf der Oberfläche der abzulegenden Folie entsprechend höher als der Abfluss der Ladungen von der Folie zu wählen.

### Literaturverzeichnis

[Sch05] Schlaak, H. F.; Matysek, M.; Lotz, P.: Novel multilayer electrostatic solid state actuators with elastic dielectric. Proceedings of SPIE. Smart Structures and Materials, 5759, S. 121-123. San Diego. 2005.

[Ran08] M. Randazzo, R. Buzio, G. Metta, G. Sandini and U. Valbusa, "Architecture for the semi-automatic fabrication and assembly of thin-film based dielectric elastomer actuators", Proc. SPIE 6927, 69272D (2008);

## Patentansprüche

1. Verfahren zur Ablage einer Folie auf einer Unterlage, **dadurch gekennzeichnet, dass** die Folie (1) unter einem Winkel an die Unterlage (2) oder die Unterlage an die Folie herangeführt wird und mindestens eine Oberfläche der Folie mit solchen elektrischen Ladungen, welche auf der gegenüberliegenden Unterlage im Unterschuss vorhanden sind, derart versehen wird, dass eine im Wesentliche blasen- und verwerfungsfreie Ablage des so versehenen Folienbereiches an der Unterlage erfolgt.

2. Verfahren nach Anspruch 1, **dadurch gekennzeichnet, dass** die mindestens eine Oberfläche durch Abgabe von Ladungen aus mindestens einer Elektrode, etwa über ein Plasma oder/und die andere Oberfläche durch eine andere, der bekannten Arten der Ladungstrennung oder Abgabe, etwa über Bestrahlung mit elektromagnetischen Wellen oder über Reibung mit Ladungen versehen wird.

3. Verfahren nach einem der Ansprüche 1 oder 2, **dadurch gekennzeichnet, dass** mindestens ein Bereich des noch nicht abgelegten Bereiches der Folie mit Ladungen versehen wird und die Unterlage relativ zur Folie oder umgekehrt mit Fortschreiten der Ablage etwa durch Rotation oder in einer wickelnden Bewegung bewegt wird.

4. Verfahren nach einem der Ansprüche 1 bis 3, **dadurch gekennzeichnet, dass** der abzulegende Bereich der Folie, etwa in einem mittigen Bereich und länglich ausgestreckt oder in einem pfeil- oder keilförmigen Bereich, in Richtung der fortschreitenden Ablage, mit Ladungen versehen wird.

5. Verfahren nach einem der Ansprüche 1 bis 4, **dadurch gekennzeichnet, dass** die der Unterlage abgewandte Oberseite der Folie im Wesentlichen im Bereich des noch abzulegenden Bereiches der Folie (1) mit Ladungen durch mindestens eine obere Elektrode (3) versehen wird.

6. Verfahren nach einem der Ansprüche 1 bis 5, **dadurch gekennzeichnet, dass** das die Unterlage (2) selber als untere Elektrode oder Gegenelektrode (4) genutzt wird.

7. Verfahren nach eine der Ansprüche 5 bis 6, **dadurch gekennzeichnet, dass** mehrere obere Elektroden (3) vorgesehen sind und sich die Unterlage relativ zur Folie rotierend oder wickelnd bewegt, wobei die Elektroden (3) zeitlich so veränderlich geschaltet werden, dass die Abgabe von Ladungen auf die sich bewegende Unterlage mindestens auf den gerade noch abzulegenden Bereich erfolgt.

8. Verfahren nach einem der Ansprüche 6 bis 7, **dadurch gekennzeichnet, dass** das zwischen der mindestens einen oberen Elektrode (3) und der Gegenelektrode Spannungen im Bereich von rund 6 kV bis 15 kV und auch darüber, d.h. zwischen 16 kV und 20 kV, sowie auch zwischen 21 kV und 30 kV, sowie bis 31 kV bis 40 kV angelegt werden, wobei die Abstände zwischen oberen und Gegenelektrode im Bereich von unter 1 mm bis zu 5 mm und auch 6 mm bis zu 10 mm und 11 mm bis oder größer 20 mm eingestellt werden.

9. Verfahren nach einem der Ansprüche 1 bis 8, **dadurch gekennzeichnet, dass** die Spannungen und Abstände so gewählt werden, dass in einem vorderen Bereich oder dem ganzen Bereich des noch abzulegenden Bereiches der Folie noch keine, aber in dem nachfolgenden Bereich auch eine Oberflächenaktivierung der Folie erfolgt.

10. Verfahren nach einem der Ansprüche 1 bis 9, **dadurch gekennzeichnet, dass** die Versorgung der Folie (1) oder der oberen Elektrode(3) und Gegenelektrode (4) oder/und Unterlage (2) mit Ladungen so ausgeführt wird, dass eine sich im Bereich der noch nicht abgelegten Folie, etwa durch Verwerfungen, abzeichnende Verwerfungs- oder/und Blasenbildung auf der Unterlage (2) unter Vermeidung dieser Bildungen geregelt ausgeführt wird.

11. Verfahren nach einem der Ansprüche 1 bis 10, **dadurch gekennzeichnet, dass** der Winkel zwischen dem im nächsten Zeitabschnitt abzulegenden Bereich der Folie und dem darauf folgenden zu beschichtenden Bereich der Unterlage oder der Tangente an den gerade noch beschichteten Bereich der Unterlage kleiner als 90°, bevorzugt 1 bis 20°, besonders bevorzugt 3° bis 20°, ganz besonders bevorzugt 5-18° beträgt und insbesondere bevorzugt im Bereich von 6 bis 12 oder 13 bis 17° liegt.

12. Vorrichtung zur Ablage von Folien auf einer Unterlage (2), insbesondere zur Ablage von Folien, geeignet zur Durchführung eines Verfahrens nach einem der Ansprüche 1 bis 11, umfassend mindestens eine Vorrichtung zur Versorgung der Folie mit elektrischen Ladungen (10), **dadurch gekennzeichnet, dass** die Vorrichtung (10) so ausgeführt ist, dass die Folie mindestens eine Versorgung im Bereich der gerade noch nicht abgelegten Folie auf der Ober- oder/und Unterseite des Folienbereiches erfährt.

13. Vorrichtung nach Anspruch 12, **dadurch gekennzeichnet, dass** die Vorrichtung (10) so ausgeführt ist, dass der versorgte Bereich der Folie länglich und in einem mittigen Bereich der Folie, etwa parallel zu deren seitlichen Rändern, angeordnet ausgeführt ist.

14. Vorrichtung nach einem der Ansprüche 12 bis 13, **dadurch gekennzeichnet, dass** die mindestens eine Vorrichtung (10) so ausgeführt ist, dass der versorgte Bereich der Folie keil- oder dreiecksförmig ausgeführt ist.

15. Vorrichtung nach einem der Ansprüche 12 bis 14, **dadurch gekennzeichnet, dass** die mindestens eine Vorrichtung zur Versorgung der Folie mit Ladungen als mindestens eine Elektrode oder ein Elektrodenfeld, oder/und als Vorrichtung zur Erzeugung oder Abgabe von Ladungen durch elektromagnetische Wellen oder durch Reibung ausgeführt ist und die Unterlage als Gegenelektrode ausgeführt ist, wobei die Gegenelektrode als ebene oder vielflächige, ebene Wickelfläche oder mit ebenen und freiformflächigen Abschnitten versehene Trommel oder als Rolle ausgeführt ist.

16. Vorrichtung nach einem der Ansprüche 12 bis 15, **dadurch gekennzeichnet, dass** die Vorrichtung ferner Mittel (11) zur Erfassung von drohenden Verwerfungen oder Blasenbildungen im Bereich der noch nicht abgelegten Folie aufweist, sowie eine Regelvorrichtung (12) zur Veränderung der Abgabe der Ladungen auf die Gegenelektrode (4) und/oder der auf die Folie und zwar mindestens in Bezug auf deren Quantität und oder den Abgabeort oder -Bereich und/oder das Abgabemuster auf die noch nicht abgelegten Folienbereiche aufweist, welche so zusammenwirkend und aufgebaut ausgeführt sind, dass eine Blasen- oder/und Verwerfungsbildung weitgehend vermieden wird.

17. Verfahren zur Herstellung von folienbasierten Aktuatoren, insbesondere DEW oder DESW, **dadurch gekennzeichnet, dass** das Verfahren ein Verfahren nach einem der Ansprüche 1 bis 11 aufweist.

18. Verfahren nach Anspruch 17, **dadurch gekennzeichnet, dass** das Verfahren eines der bekannten Sprüh- oder/und Druckverfahren zur Herstellung der Elektroden zwischen den Folienlagen vorsieht.

19. Vorrichtung zur Herstellung von folienbasierten Aktuatoren, **dadurch gekennzeichnet, dass** die Vorrichtung eine Vorrichtung nach einem der Ansprüche 12 bis 16 aufweist.

20. Vorrichtung nach Anspruch 19, **dadurch gekennzeichnet, dass** die Vorrichtung mindestens zwei parallel mit Folie versorgte und rotierende Unterlagen(2) in Form von ebenen Wickelflächen oder/und eine oder jeweils einer Unterlage zugeordnete Vorrichtung zur Aufbringung von Elektroden auf den Folien nach den bekannten Sprüh- oder/und Druckverfahren aufweist.

21. Verwendung eines Verfahrens oder einer Vorrichtung nach einem der vorgenannten Ansprüche 1 bis 20 zur Herstellung von elektronischen Bauteilen, aufweisend Folienstapel, insbesondere zur Herstellung von Kondensatoren.
